# EUROPÄISCHE PATENTSCHRIFT

(11) **EP 2 326 746 B1**
(45) Veröffentlichungstag und Bekanntmachung des Hinweises auf die Patenterteilung: **16.04.2014**
(21) Anmeldenummer: 09782497.3
(22) Anmeldetag: 02.09.2009
(51) Int. Cl.: C23C 18/16, C23C 18/18, H01L 51/05, C23C 18/30, H01G 4/33, H01G 4/18, H05K 1/16, H05K 3/38

(54) **ANKERGRUPPE FÜR MONOLAGEN ORGANISCHER VERBINDUNGEN AUF METALL UND DAMIT HERGESTELLTES BAUELEMENT AUF BASIS ORGANISCHER ELEKTRONIK**
ANCHOR GROUP FOR MONOLAYERS OF ORGANIC COMPOUNDS ON METAL AND COMPONENT PRODUCED THEREWITH BY MEANS OF ORGANIC ELECTRONICS
GROUPE D'ANCRAGE POUR MONOCOUCHES DE COMPOSÉS ORGANIQUES SUR MÉTAL ET COMPOSANT ÉLECTRONIQUE ORGANIQUE RÉSULTANT

(30) Priorität: 23.09.2008 DE 102008048446; 07.04.2009 DE 102009016659
(43) Veröffentlichungstag der Anmeldung: 01.06.2011
(60) Teilanmeldung: 13005664.1
(73) Patentinhaber: Siemens Aktiengesellschaft, 80333 München (DE)
(72) Erfinder: SCHMID, Günter, 91334 Hemhofen (DE); TAROATA, Dan, 91054 Erlangen (DE)
(86) Internationale Anmeldenummer: PCT/EP2009/061323
(87) Internationale Veröffentlichungsnummer: WO 2010/034597

(56) Entgegenhaltungen:
- DE-A1-102004 005 082
- DE-A1-102004 009 600
- DE-A1-102004 057 531
- US-A1- 2007 114 516
- US-A1- 2008 131 709
- JOHN G. VAN ALSTEN: "Self-Assembled Monolayers on Engineering Metals: Structure, Derivatization, and Utility" LANGMUIR, Bd. 15, Nr. 22, 26. August 1999 (1999-08-26), Seiten 7605-7614, XP002573911

## Beschreibung

Die Erfindung betrifft einen Kondensator, der in eine Leiterplatte, einen Prepreg oder eine Platine integriert ist, wobei die Platine, Leiterplatte oder das Prepreg als Substrat dient, das als Kupfersubstrat oder Kupfer enthaltendes Substrat ausgebildet ist, auf welchem Substrat eine elektrisch isolierende organische Zwischenschicht und eine auf diese folgende Schicht ausgebildet sind, wobei die elektrisch isolierende organische Zwischenschicht als eine als selbstorganisierende Monolage ausgebildete organische Verbindung mit einer Ankergruppe auf einer Kupferschicht oder Kupfer enthaltenden Schicht, einer Linkergruppe und einer Kopfgruppe zur Anbindung an die folgende Schicht, wobei die Ankergruppe zumindest eine Phosphonsäure und/oder ein Phosphonsäurederivat enthält, die/das direkt auf dem Kupfersubstrat oder dem Kupfer enthaltenden Substrat anknüpft, ausgebildet ist.

Im Sinne der Miniaturisierung ist es besonders vorteilhaft, dünnste Schichten, insbesondere Monolagen, mit genau angepasster Funktionalität in elektronischen Bauelementen, insbesondere auch in organischen elektronischen Bauelementen, einzusetzen. Damit Moleküle in Monolagen sich selbst organisieren und damit höchste Funktionalität und Funktionsdichte zeigen, empfiehlt es sich, sie an den jeweiligen Elektroden durch Kopf- oder Ankergruppen festzumachen, wodurch eine Ausrichtung der Linkergruppen, also der die beiden Enden verbindenden Gruppen, automatisch erfolgt. Die Anbindung an das Substrat findet spontan statt, sofern das Substrat entsprechend vorbereitet wurde.

Die spezifische Funktionalität wird durch die Linker und Kopfgruppen bestimmt. Der Anker bestimmt die Selbstorganisation.

Dazu bekannt ist beispielsweise aus der DE 10 2004 005 082 B4 eine aromatische, chemisch aufwändig einzuführende Kopfgruppe mit π-π-Wechselwirkung, die eine selbstorganisierende Dielektrikumschicht an eine Elektrode bindet. Als Anbindung an die Gegenelektrode, als so genannte Ankergruppe der organische dielektrische Verbindung, die als Monolage in einem Kondensator einsetzbar ist, dient gemäß der DE 10 2004 005 082 B4 eine Silanverbindung, die über eine Oxidschicht, gebildet aus einem Nicht-Kupferoxid an die Elektrode anbindbar ist. Insbesondere kann die die Dielektrikumsschicht bildende Ankergruppe gemäß DE 10 2004 005 082 B4 aus der Gruppe bestehend aus R-SiCl₃, R-SiCl₂-Alkyl, R-SiCl(Alkyl)₂, R-Si(OR)₃, R-Si(OR)₂-Alkyl, R-SiOR(Alkyl)₂, R-Po(OH)₂, R-CHO und/oder R-CH=CH₂ ausgewählt sein.

US 2008/0131709 A1 offenbart ein Bauteil mit einem mehrschichtigen Aufbau. Das Bauteil besteht aus einem Substrat, auf dessen Oberfläche eine dünne Schicht aus Kupfer bzw. einer Kupferlegierung abgeschieden ist. Auf der dünnen Schicht aus Kupfer bzw. einer Kupferlegierung ist eine Adhäsionsschicht ausgebildet bzw. kovalent angebunden, welche Adhäsionsschicht wenigstens ein Organophosphonat aufweisen kann. Auf der Adhäsionsschicht ist eine Funktionsschicht ausgebildet bzw. kovalent angebunden, welche Funktionsschicht aus wenigstens einem Polymer gebildet ist.

Nachteilig an dem bekannten Stand der Technik ist, dass die Elektrodenoberfläche, also beispielsweise die Kupferoberfläche bevorzugt zur Aufbringung der selbst organisierenden Monolage mit Aluminium oder Titan funktionalisiert werden muss, das dann eine oxidische Oberfläche zur Anbindung zur Verfügung stellt. Ein solcher Funktionalisierungsschritt der Elektrodenoberfläche ist jedoch sehr kostenintensiv, da zunächst Nicht-Kupfermetalle aufgebracht und strukturiert werden müssen. Hinzu kommt, dass die Elektrodenoberflächen, wenn sie nach herkömmlichen Methoden auf herkömmlichen Platinen oder Leiterplatten oder Prepregs prozessiert werden, in der Regel eine Oberflächenrauhigkeit aufweisen, die im Bereich von ca. 4 µm liegt. Diese Rauhigkeit limitiert die mechanische Stabilität einer mit einer Monolage beschichteten Oberfläche, da an den Korngrenzen die Lücken nicht zwingend vollständig abgedeckt sind bzw. an Substratspitzen hohe Feldstärken entstehen. Die Höhe der Monolage, in der Regel ca. 2 bis 5, maximal 20nm planarisiert aufgrund der konformen Abscheidung die Rauhigkeit nicht.

Aufgabe der vorliegenden Erfindung ist es deshalb, die Nachteile des Standes der Technik zu überwinden und insbesondere, eine Ankergruppe für eine selbstorganisierende Monolage (SAM) zur Verfügung zu stellen, die eine Aufbringung der SAM-Beschichtung auf eine mit herkömmlichen Methoden hergestellte und vorbereitete Kupfer-Elektrode ermöglicht.

Lösung der Aufgabe und Gegenstand der Erfindung sind in den unabhängigen und abhängigen Ansprüchen, der Beschreibung und den Figuren enthalten.

Gegenstand der Erfindung ist ein Kondensator, der in eine Leiterplatte, einen Prepreg oder eine Platine integriert ist, wobei die Platine, Leiterplatte oder das Prepreg als Substrat dient, das als Kupfersubstrat oder Kupfer enthaltendes Substrat ausgebildet ist, auf welchem Substrat eine elektrisch isolierende organische Zwischenschicht und eine auf diese folgende Schicht ausgebildet sind, wobei die elektrisch isolierende organische Zwischenschicht als eine als selbstorganisierende Monolage ausgebildete organische Verbindung mit einer Ankergruppe auf einer Kupferschicht oder Kupfer enthaltenden Schicht, einer Linkergruppe und einer Kopfgruppe zur Anbindung an die folgende Schicht, wobei die Ankergruppe zumindest eine Phosphonsäure und/oder ein Phosphonsäurederivat enthält, die/das direkt auf dem Kupfersubstrat oder dem Kupfer enthaltenden Substrat anknüpft, ausgebildet ist.

Als "organische Verbindung für eine selbstorganisierende Monolage" werden vorstehend Verbindungen bezeichnet, die sich aufgrund einer bestimmten Ankergruppe in der Schicht ausrichten, so dass eine Mehrzahl der Moleküle parallel und/oder gleich ausgerichtet in der Schicht vorliegt. Beispielsweise werden in der DE 10 2004 005 082 B4 entsprechende organische Verbindungen beschrieben, die Monolagen in der Dielektrikumsschicht eines Bauelements auf Basis organischer Elektronik bilden können. Die gemäß vorliegender Erfindung einsetzbaren organischen Verbindungen unterscheiden sich von diesen zumindest durch eine verschiedene Kopf- und/oder Ankergruppe. Darüber hinaus können gemäß der vorliegenden Erfindung viele kommerziell erhältliche Materialien Anwendung finden und zur Herstellung von dichten Monolagen hergenommen werden.

Erfindungsgemäß wird ein Kondensator direkt auf einer Platine, beispielsweise einer nach üblichen Herstellungsmethoden produzierten Kupferplatine, aufgebaut, ohne dass diese durch ein weiteres Metall funktionalisiert oder durch spezielle Verfahren geglättet wird. Die Metallschicht, auf der die Ankergruppe aufgebracht wird, ist demnach eine Kupferschicht oder Kupfer enthaltende Schicht, wobei der Anteil an Kupfer in der Schicht bevorzugt über 10%, insbesondere bevorzugt über 40% und ganz besonders bevorzugt über 70%, gemessen in Molprozent, beträgt.

Eine separate Vorbereitung der Substratoberfläche erübrigt sich. Die Vorbereitung beinhaltet nur Reinigungsschritte und nicht das Aufbringen zusätzlicher Materialien, wie nach dem Stand der Technik üblich.

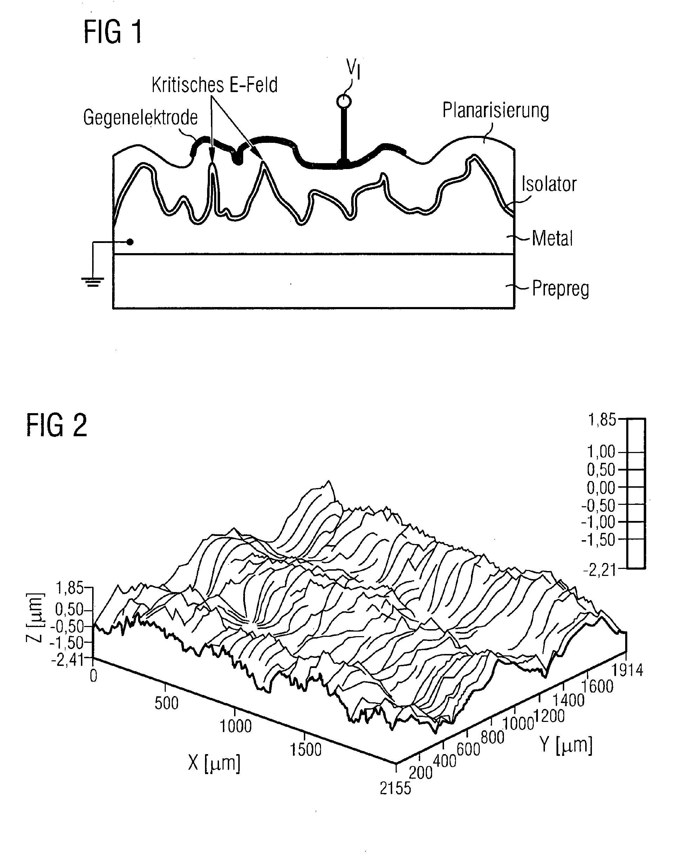

Insbesondere ist es möglich, einen Kondensator kostengünstig direkt auf eine so genannte dekapierte Kupferoberfläche aufzubauen. In Figur 1 wird ein derartiger Aufbau am Beispiel eines Kondensators gezeigt.

Als Basismaterial für den Kondensator dient eine nach gebräuchlichen Methoden dekapierte Kupferplatine mit einer Auflage von ca. 5 - 30 µm und einer Rauhigkeit im µm-Breich. Die Dekapierung kann wie üblich durch Entfetten mit organischen Lösungsmitteln und anschließendem Anätzen mit Peroxodisulfaten und Schwefelsäure erfolgen. Fig. 2 visualisiert die Rauhigkeit eines dekapierten Leiterplattensubstrates.

Eine zusätzliche Reinigung der Kupferoberfläche kann, wie in der Galvanotechnik üblich, kathodisch erfolgen. Dazu wird in verdünnter Natriumcarbonatlösung das Substrat als Kathode geschaltet und bei einem Stromfluss von 10 - 100 mA/cm² durch den entstehenden Wasserstoff gereinigt.

Durch die Dekapierung beträgt der Kontaktwinkel gegenüber Wasser kleiner 5°. Die Kupferoberfläche wird dadurch sehr hydrophil. Zur Vermeidung der Oxidation des Kupfers und als Primer für die nachfolgende dünne, nur lokal planarisierende Polymerabscheidung wird im unmittelbarem Anschluss eine Monolage einer organischen Phosphonsäure abgeschieden. Die Phosphonsäureankergruppe hat sich insbesondere für Kupfer als bestens geeignet erwiesen, während in DE 10 2004 005 082 B4 vorzugsweise mit Silanen gearbeitet wurde (Ausführungsbeispiel) und die Kupferoberfläche bevorzugt zur Abscheidung mit Aluminium oder Titan funktionalisiert werden muss. Ein solcher Funktionalisierungsschritt der Kupferoberfläche entfällt in dem vorgestellten Bauelement vollständig.

Bevorzugt sind die langkettigen Phosphonsäuren, wie Decylbis Octadecylphosphonsäure, allgemein CH₃-(CH₂)ₙ-PO(OH)₂, wobei n = 8 - 25, bevorzugt n = 18. Die Molekülkette kann auch als Polyetherkette ausgebildet sein (-O-CH₂-CH₂-O-)ₘ, wobei m zwischen 1 und 20, bevorzugt zwischen 2 und 10 liegt. Der Kontaktwinkel gegenüber Wasser erhöht sich nach Abscheidung einer Octadecylphosphonsäure auf > 130° für Alkylphosphonsäuren und ist damit ein Indiz für die Qualität der Abscheidung.
Die Alkylketten können auch ganz oder teilweise fluoriert sein.

Alternativ kann die Abscheidung auch über die Phosphonsäureester bzw. deren Salze oder andere Derivate wie Amine etc erfolgen. Die Salze können direkt in Lösung durch Zugabe geringerer oder äquivalenter Mengen an Lauge (NaOH, KOH, Ammoniak oder Ammoniumhydroxide) erhalten werden.

Als Kopfgruppe können bei Einsatz eines Stützpolymers einfachste verzweigte, unverzweigte Alkyl- oder für weitere Reaktionen (i.e. Vernetzung) geeignete Alkenylgruppen dienen. Zur Verbesserung der Anknüpfung der Monolage an das Stützpolymer kann die Kopfgruppe eine Fluor, Nitril, Amino, Ester, Aldehyd, Epoxy oder Säurefunktion darstellen. Im Falle einer Fluorierung könnte die Kopfgruppe aus -CF₃, -CHF₂, CH₂F. bestehen.

Zur Erhöhung der mechanischen Stabilität wird nach einer vorteilhaften Ausführungsform der Erfindung auf die Monolage zur Stabilisierung und/oder für die lokale Planarisierung des Kondensators oder Bauteils ein Stützpolymer, also eine dünne Polymerlage aufgebracht. Typischerweise ergibt sich für eine Integrationsdichte von 50pF/mm² bei einer Dielektrizitätskonstante von 3,17 eine effektive Polymerschichtdicke von ca. 550 - 600 nm, während sich für eine Integrationsdichte von 150 pF/mm² eine effektive Schichtdicke von 180 - 200 nm ergibt. In den Senken wird mehr Polymer eingebracht, während an den Spitzen ein dünnerer Polymerfilm vorliegt. Gegenüber dem von 3M vorgestellten Ansatz kann die Bauelementdicke von 14 µm um einen Faktor 70 gesenkt werden bei gleichzeitiger Erhöhung der Kapazität um einen Faktor 15.

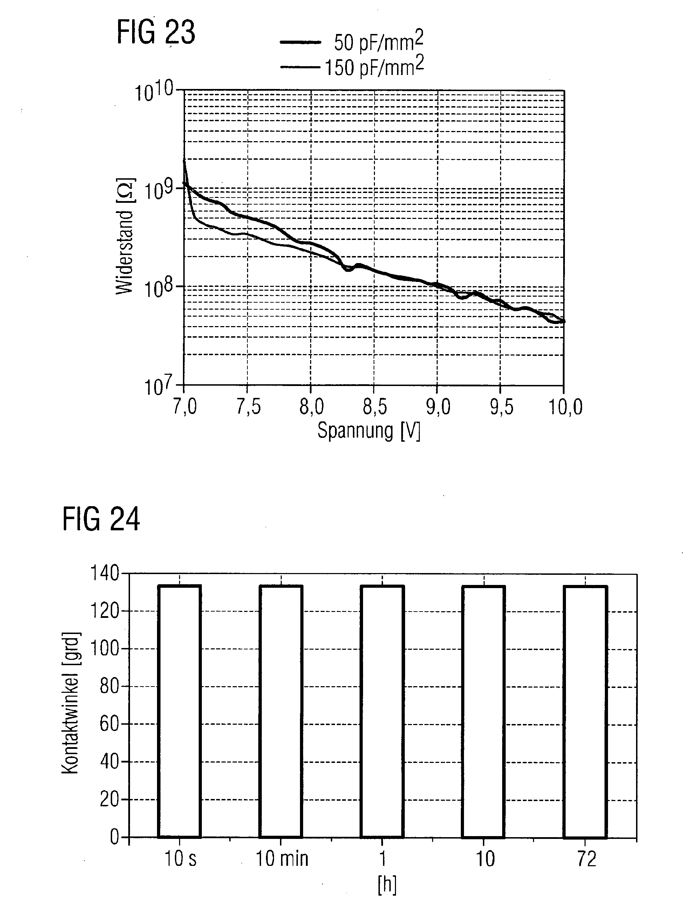

Das Leckstromverhalten des hier gezeigten Kondensators wird fast ausschließlich durch die selbstorganisierende Monolage bestimmt. Deshalb wurde auch gemessen, (vergleiche dazu Figur 24), dass die Widerstände von der Stabilisierungspolymerdicke unabhängige Verläufe aufweisen weil der wesentliche Beitrag zum ohmschen Gesamtwiderstand des Kondensators gegen Gleichstrom von der Selbstorganisierenden Monolage geleistet wird. Daher können zur Planarisierung beliebige Polymere verwendet werden, sofern sie mit den Leiterplattenprozessen kompatibel sind.

Beispielsweise wurde durch Melamin-Co-formaldehyd vernetztes Poly-hydroxystyrol verwendet. Eine gute planarisierende Wirkung wurde erreicht, wenn das Polyhydroxystyrol eine Molmasse im Bereich von 500 bis 100000, insbesondere von 3500 bis 50000, insbesondere bevorzugt von 8000 aufwies. Die Vernetzung wurde bevorzugt im Temperaturbereich zwischen 180°C-230°C durchgeführt. Nach der Vernetzung wird die Polymerschicht zur mechanischen Stabilisierung nicht mehr durch Lösungsmittel angegriffen.

Neben den Novolack-artigen Polymeren können auch Harze auf der Basis von Epoxiden, Acrylaten, Urethanen oder Carbonaten, Verwendung als Stützpolymere finden. Weitere Polymere: Polyester, Polyamide, Polyimide, Polybenzoxazole, Polyvinylidendifluorid (allg. teflonartige Materialien), Polyvinylverbindungen (Carbazole, Alkohole und deren Ester). Co-polymere bzw. Block-co-polymere wie ABS sind ebenfalls geeignet. Die Molmasse der Polymere kann im Bereich zwischen 1000 und 1 000 000 liegen.

Die lokal planarisierenden Polymerschichten können folgendermaßen aufgebracht werden:
a. aus Lösung. Dazu werden 1 - 50 %, bevorzugt 5 - 20% des Polymers mit oder ohne Vernetzer in einem organischen Lösungsmittel gelöst (PGMEA = PropylenGlykolMonoEthyletherAcetat, Tetrahydrofuran, Dioxan, Chlorbenzol, Diethylenglykoldiethylether, Diethylenglykolmonoethylether, gamma-Butyrolacton, N-Methylpyrollidinon, Ethoxyethanol, Xylol, Toluol etc.) und durch Spincoating, Drucken (Siebdruck, Tintenstrahldruck Sprühen etc.) in entsprechender Dicke aufgebracht. Im Anschluss wird das Lösungsmittel durch einen Temperschritt verdampft, wobei die staubtrockene bzw. ausgehärtete Polymerschicht übrig bleibt. Die Polymere können thermisch oder photochemisch vernetzt werden. Die Vernetzung ist optional. Für Polyvinylalkohol ist beispielsweise auch Wasser als Lösungsmittel geeignet. Mögliche Vernetzer sind Photosäuren.
b. Im Falle von Acrylaten und Epoxiden können die Monomere oder Oligo-Verbindungen durch Spincoating oder Drucken (siehe oben) aufgebracht werden und im Anschluss thermisch oder photochemisch zum Dielektrikum vernetzt werden.

Als Deckelektroden für den Kondensator kann jedes Metall, bzw. dessen Legierung oder leitfähige metallhaltige Druckpasten dienen. Ebenfalls geeignet sind organische Leiter, wie PEDOT (polystyrolsulfonsäure dotiertes Polydiethoxythiophen) oder PANI (champersulfonsäuredotiertes Polyanilin). Besonders bevorzugt sind jedoch die in der Leiterplattenindustrie benutzten Metalle Kupfer, Aluminium, Nickel, Gold und Silber bzw. deren Legierung. Vollflächige aufgebrachte Metallgegenelektroden können im Anschluss durch die dem Fachmann bekannten Ätz- und mechanischen Ablationsverfahren (Laser) strukturiert werden. Werden mehrere Kondensatoren mit einer gemeinsamen Gegenelektrode versehen, kann die Abscheidung der Gegenelektrode auch aus der Gasphase mittels Schattenmasken erfolgen (siehe Ausführungsbeispiele).

Die Gegenelektroden können auch durch stromlose Metallisierung nach lokaler oder vollflächiger Bekeimung aufgebracht werden. Im Prinzip können alle Verfahren der Leiterplattenindustrie verwendet werden. Da das Dielektrikum nach der Vernetzung gegenüber den üblichen Medien der Leiterplattenindustrie kompatibel ist.

Die Kopfgruppe stabilisiert normalerweise die Monolage selbst. In der Regel bewirkt die Kopfgruppe die Anbindung der SAMs an die gegenüberliegende Schicht. Unter Anbindung wird dabei jede Form der Bindung, insbesondere eine chemische Bindung, die von einer kovalenten Doppelbindung über ionogene Bindungen bis zu einfachen van der Waals Bindungen reichen kann, verstanden.

Die Kopfgruppe kommt in einem Kondensator mit stabilisierender Polymerdeckschicht, wie nach einer vorteilhaften Ausführungsform der Erfindung vorgesehen, nicht mit der Elektrode in Berührung. Mit der Deckelektrode kommt nur die Polymerschicht in Berührung. Diese lässt sich dann mit den bekannten Verfahren funktionalisieren, wie beispielsweise durch Bedampfen oder Besputtern mit Metallen, Bedrucken mit Metallpasten etc. Experimentell hat sich gezeigt, dass dann auch auf eine aufwändige Kopfgruppe verzichtet werden kann. Die Wechselwirkung der einzelnen Ketten ist grundsätzlich ausreichend für die Stabilisierung der selbstorganisierenden Monolage, jedoch kann eine Kopfgruppe auch bei Einsatz einer Polymerdeckschicht zur Stabilisierung der Monolage die elektrischen Eigenschaften verbessern.

Der vorgesehene Aufbau einer Elektrodenschicht mit einer darauffolgenden Isolatorschicht kann natürlich nicht nur in einem Kondensator vorteilhaft eingesetzt werden, sondern er eignet sich prinzipiell auch für folgende nicht erfindungsgemäße Anwendungen:
Als
   1. Gatedielektrikum für organische Feldeffekttransistoren zur direkten Integration in die Leiterplatte.
   2. Substrat für topemitterende OLED (Die Kupferschicht ist hermetisch dicht). Auf der dünnen Isolierung können dann die Elektroden für die OLED abgeschieden werden.
   3. Analog dem Aufbau für die OLEDs eignet sich die Schichtfolge auch für Solarzellen.

### Beispiel 1:

Das im Folgenden beschriebene Beispiel 1 ist nicht erfindungsgemäß, sondern bezieht sich auf die in DE 10 2004 005 082 B4 beschriebenen Prinzipien. Für den Versuchsaufbau wird eine mit 30µm Kupfer kaschierte FR4-Platine auf ein Maß 50 x 50 m² zugeschnitten. Diese wird zunächst mit Aceton und Isopropanol von Fett befreit. Ein kommerzieller Photolack (TMSR8900) wird 20s bei 6000rpm aufgeschleudert und 60s bei 110°C auf einer Hotplate getrocknet. Der Photolack wird 7s mit UV-Licht einer Wellenlänge von 365 nm belichtet und 60s in wässrig-alkalischem Entwickler entwickelt.

Im Anschluss an die Fotostrukturierung wird 3 min bei 40°C in einer 5 % Ammoniumperoxodisulfatlösung dekapiert. Nach dem Spülen mit Wasser und Isopropanol wird die Platine in eine Lösung von Octadecylphosphonsäure (0.2 -0.25 g) in Isopropanol (100 ml) gelegt. Nach 12 Stunden wird die Platine mit Isopropanol gespült und 1 min bei 100°C im Stickstoffstrom getrocknet.

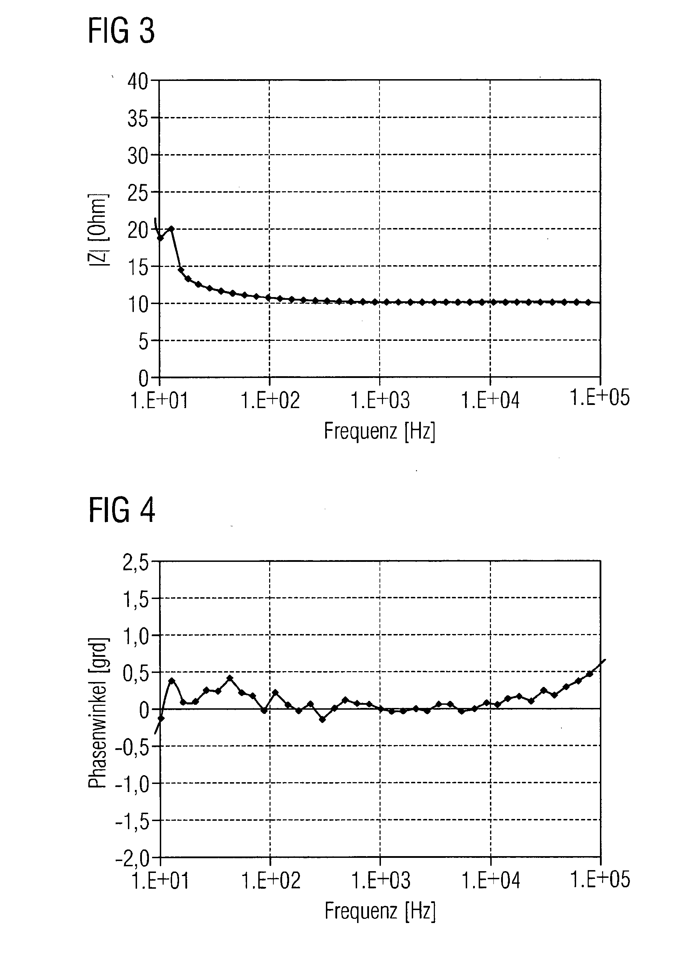

Nach dem Dekapieren beträgt der Kontaktwinkel gegenüber Wasser 1° bis 4°. Nach der Abscheidung der Octadecylphosphonsäure beträgt der Kontaktwinkel 135°, was auf eine exzellente Bedeckung der Kupferschicht schließen lässt. Im Anschluss daran werden 100 nm Aluminium über eine Schattenmaske als Gegenelektroden aufgedampft. Beispielsweise wurde so ein prozessiertes Kapazitätenmuster auf einer FR4-Leiterplatte hergestellt. Die elektrischen Kennlinien (Betrag ca. 10 Q und Phasenwinkel der Impedanz ca. 0°) in den Figuren 3 und 4 zeigen, dass alle Kondensatoren kurzgeschlossen sind. Ein idealer Kondensator hätte einen Durchgangswiderstand von unendlich. 10 Ohm ist ein Kurzschluss d.h. der Kondensator ist nicht funktionsfähig. Es zeigt sich dass für Standardleiterplatten mit einer Rauhigkeit im µm-Bereich ohne Ti oder Al-Vorbehandlung bzw. ohne das Vorhandensein einer aromatischen Kopfgruppe am Primer das Verfahren aus DE 10 2004 005 082 B4 zum Aufbau von Kondensatoren in hoher Ausbeute nicht geeignet ist.

An weiteren Beispielen wird gezeigt, dass mit einem Primer auch ohne chemisch aufwändig einzuführende Kopfgruppe mit π-π-Wechselwirkung direkt auf Kupfer hochkapazitiven Kondensatoren aufgebaut werden können. Auf der Kupferoberfläche sitzt direkt die Ankergruppe, also die Phosphonsäuregruppe.

### Beispiel 2: Integrationsdichte 50 pF/mm²:

Analog zu Beispiel 1 wird eine kupferkaschierte FR4-Leiterplatte oder ein Prepreg mit dem Primer Octadecylphosphonsäure oder Hexadecylphosphonsäure beschichtet. Eine Lösung von 0.8g Polyvinylphenol (Molmasse 8000) mit 0.2g Polymelamincoformaldehyd -Vernetzter werden in 5.67g Propylene-glycol-monomethyl-etheracetat gelöst und 40s bei 2500rpm aufgeschleudert und 60s bei 100°C auf einer Hotplate vorgetrocknet. In einem Vakuumofen wird das Novolack-artige Polymer mit dem Formaldehydvernetzer bei 180°C bis 230°C ausgehärtet. Im Anschluss daran werden analog Beispiel 1 Aluminiumelektroden durch Verdampfen (Basisdruck 1*10⁻⁶ mbar) abgeschieden. Andere Integrationsdichten können durch Anpassung der Schleuderdrehzahl erhalten werden.

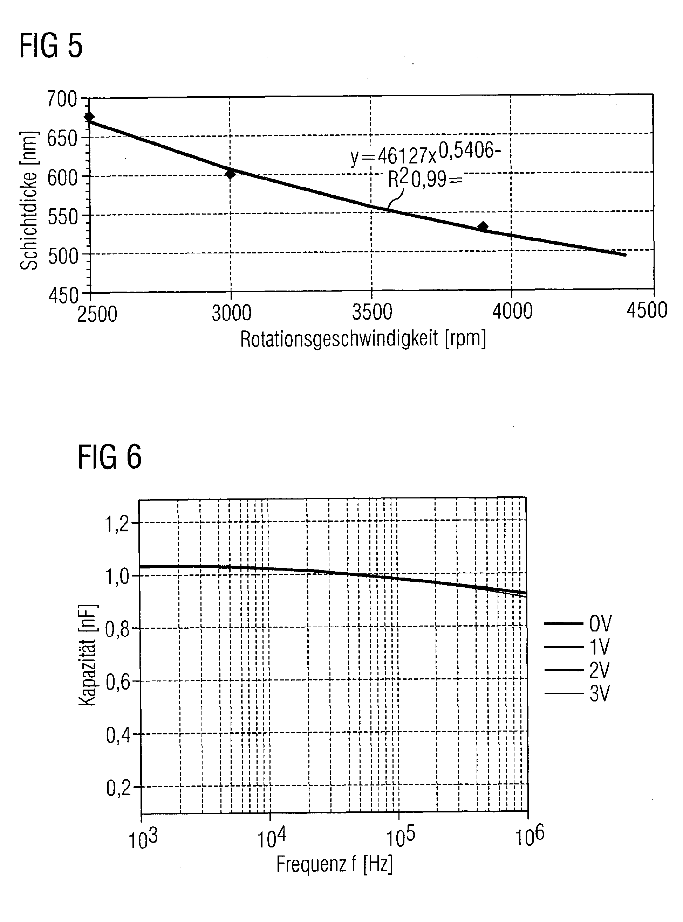

Figur 5 zeigt eine Spinkurve - wobei die effektive mittlere Schichtdicke der Polymerschicht als Funktion der Schleudergeschwindigkeit dargestellt wird.

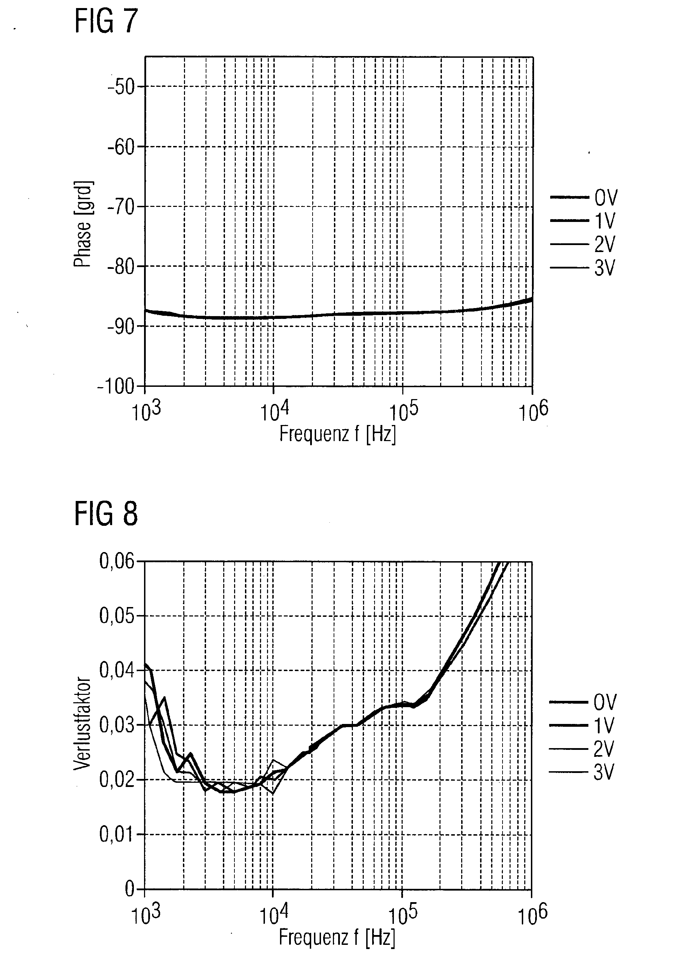

Figuren 6 bis 9 zeigen die Abhängigkeit der Kapazität (6), der Phase der Impedanz (7) und des Verlustfaktors (8) eines realisierten Kondensators mit der Integrationsdichte von 49pF/ mm² (9), von der Frequenz und angelegter Gleichspannung. Die elektrischen Kenndaten sind in den Figuren 6 bis 9 dargestellt. Die Abhängigkeit der gemessenen Kapazität von der Frequenz ist gering, was die Qualität des vorgestellten Kondensators demonstriert. Die Phase der Impedanz des realisierten Kondensators nimmt im dargestellten Frequenzbereich Werte zwischen -89° und -87° an. Der Verlustfaktor lag im Bereich von 0.0x und ist, wie Figur 8 zeigt, ebenfalls nahezu unabhängig von der Frequenz. Außerdem ist keine Abhängigkeit der in den Figuren 6 bis 9 dargestellten Parameter von der angelegten Gleichspannung zu erkennen. Bei den Messungen wurden Bias-Spannungen zwischen 0V und 3V eingestellt, während die Amplitude der überlagerten Wechselspannung, derer Frequenz zwischen 1kHz und 1MHz variiert wurde, 0.1V betragen hat.

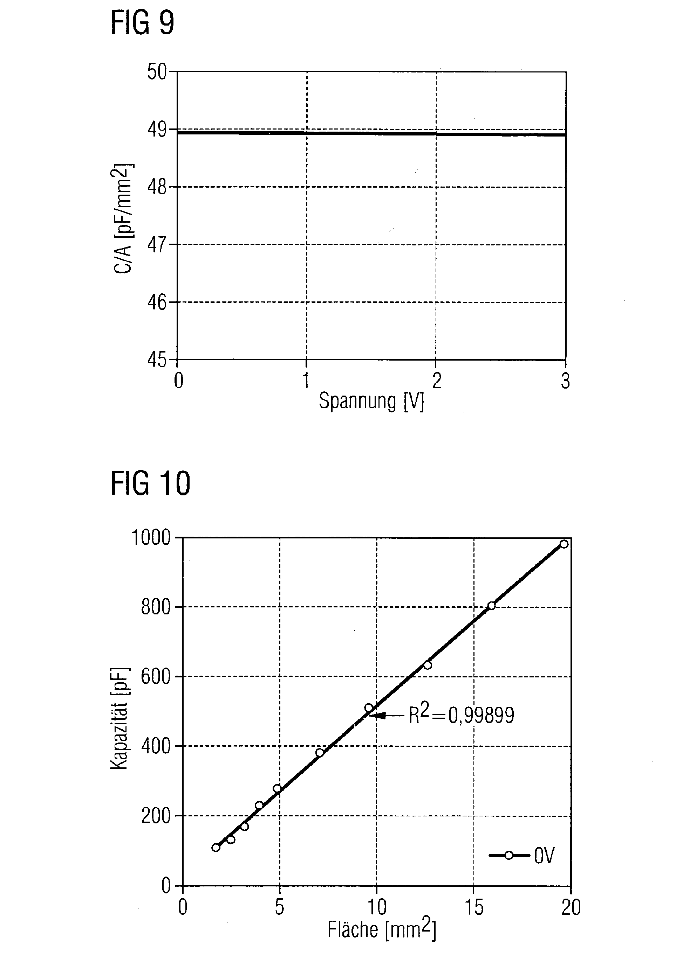

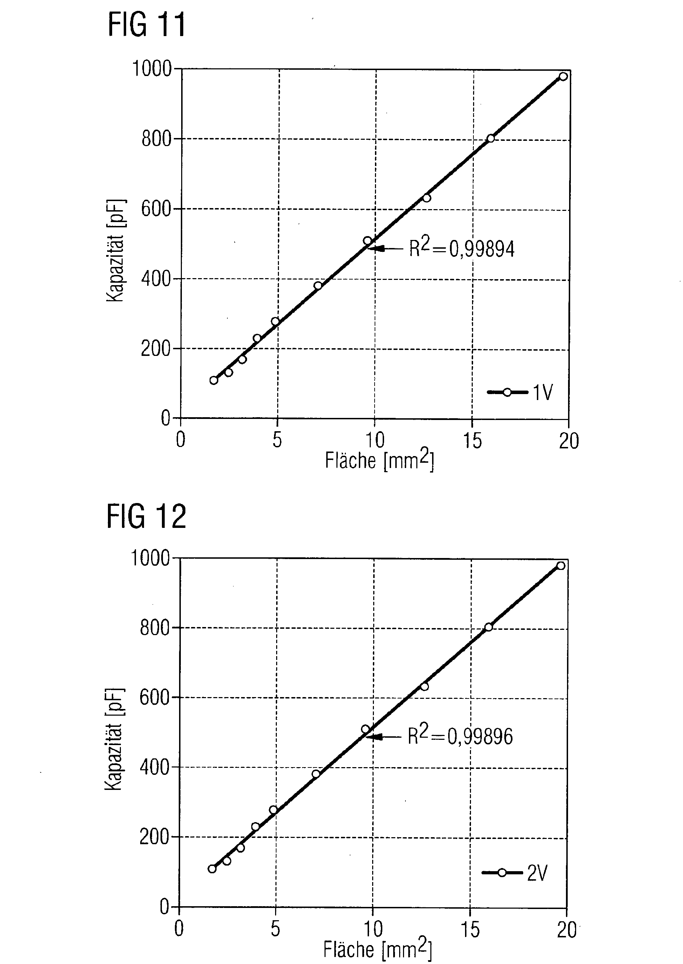

Die Figuren 10 bis 13 zeigen die Abhängigkeit der Kapazität von der Elektrodenfläche. Das streng lineare Verhalten zeigt, dass sich auch großflächige Kapazitäten (20 mm² = 1 nF) herstellen lassen. Die Ausbeute an funktionsfähigen Substraten ist auf einem Substrat gemäß Beispiel 1 100%. Die Qualität der Kondensatoren ist damit vergleichbar mit diskreten SMD Bauteilen (Verlustfaktor von 0.035 bei käuflichen Keramik SMD Kondensatoren).

Figuren 10 bis 13 zeigen die Abhängigkeit der Kapazität von der Elektrodenfläche bei 0V bis 3V bei 50pF/mm².

Figuren 14 und 15 zeigen die Leckstrommessung für einen Kondensator mit einer Integrationsdichte von 50 pF/mm² und (14) runden bzw. (15) eckigen Elektroden.

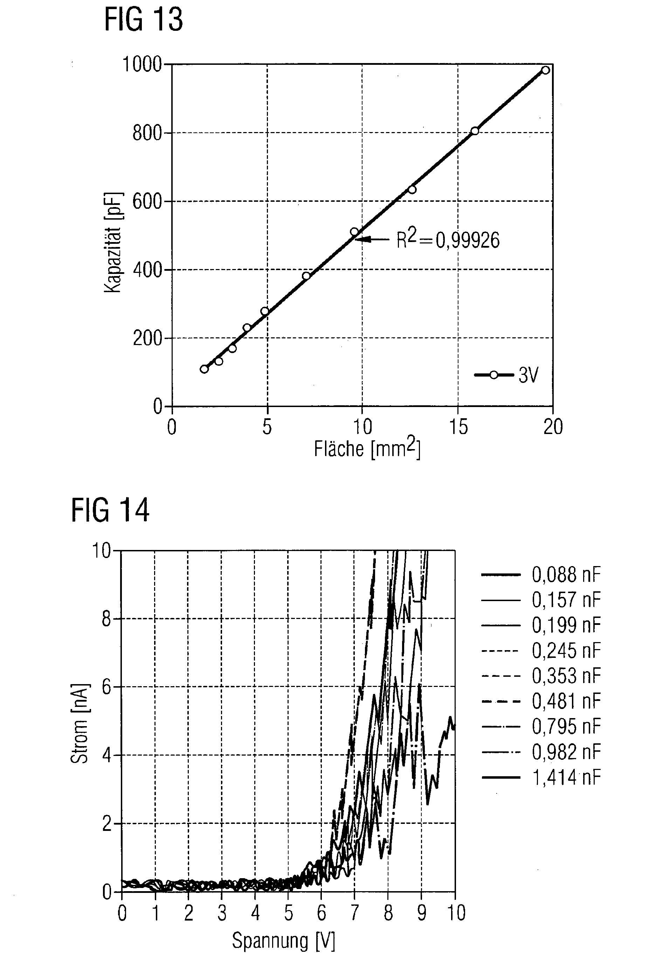

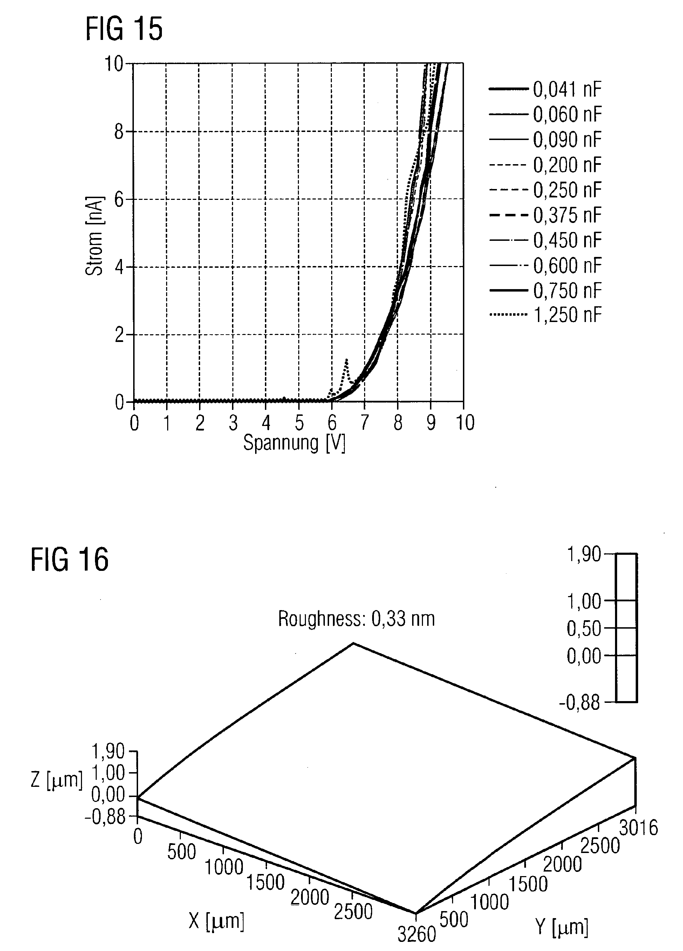

Die Figuren 14 und 15 zeigen den gemessenen Leckstrom in Abhängigkeit der angelegten Gleichspannung bei Kondensatoren mit verschiedenen Elektrodenflächen. Die Messkurven zeigen keinen tatsächlichen Durchbruch, sondern lediglich einen ab 7VDC erhöhten Leckstrom (2nA bis 4nA), der jedoch im Vergleich zu SMD Bauelementen klein ist. Außerdem ist keine Abhängigkeit der in den Figuren 14 und 15 gemessenen Ströme von der Elektrodenform zu erkennen.

Die Dielektrizitätskonstante des vernetzen Polymers wurde wie folgt bestimmt. Wegen der zu hohen Rauhigkeit der FR4 Substrate (siehe Figur 2) ist eine genaue Bestimmung der Dielektrikumsdicke unmöglich. Aus diesem Grund wurden Kondensatoren auf einem Substrat mit möglichst geringer Rauhigkeit realisiert. Dazu wurden Glassubstrate als Träger gewählt. Mit Hilfe eines Profilometers wurde zuerst das Profil eines solchen Substrates untersucht. Figur 16 zeigt die Rauhigkeitsmessung an einer Glasprobe.

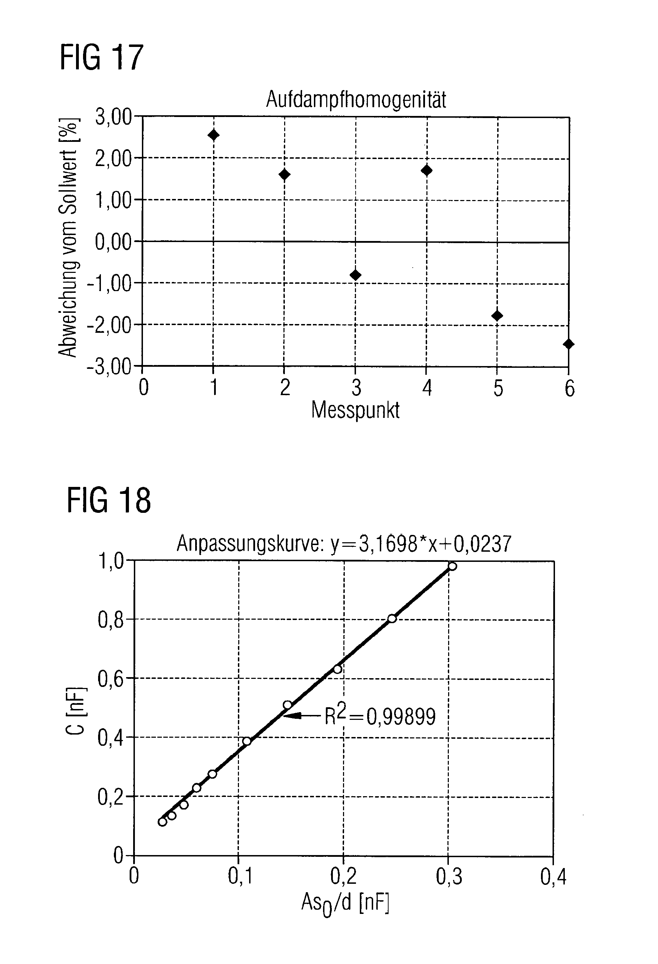

Wie in Figur 16 zu erkennen ist, liegt die Rauhigkeit im Bereich von 0.20nm bis 0.33nm. Für die weitere Charakterisierung der Kondensatoren wurden beide Elektroden auf dem Substrat durch einen Aufdampfprozess aufgebracht. Die Homogenität der aufgedampften Schichten ist in Figur 17 dargestellt.

Gedampft wurde eine 100 nm dicke Kupferschicht. Die Ecken der Glasprobe wurden mit Kaptonband als Schattenmaske abgeklebt. Nach dem Aufdampfverfahren wurde das Kaptonband entfernt und die Schichtdicke mit Hilfe eines Profilometers gemessen.

Nach der Abscheidung der SAM auf dem Substrat, wurde die Polymerschicht durch Rotationsbeschichtung aufgebracht (20 Gew % Polymerlösung, 2500rpm Rotationsgeschwindigkeit). Vor diesem Prozessierungsschritt wurde die Probe erneut an einer Ecke mit Kaptonband versehen. Dadurch wurde eine definierte Stufe geschaffen, an welcher die Dicke des Dielektrikums bestimmt werden kann. Die nachfolgende Schichtdickenmessung hat eine effektive mittlere Dicke von 573 nm ergeben. Mit Hilfe eines erneuten Aufdampfschrittes wurde die obere Elektrode der Kondensatoren realisiert.

Durch die Auftragung der gemessenen Kapazität als Funktion des Produktes zwischen Elektrodenfläche, Dielektrizitätskonstante für Vakuum und dem Kehrwert des Abstandes zwischen den beiden Kondensatorplatten kann graphisch die relative Dielektrizitätskonstante bestimmt werden.

Figur 18 zeigt die Messung zur Bestimmung der relativen Dielektrizitätskonstanten.

Für die relative Dielektrizitätskonstante wurde durch die beschriebenen Messungen, unter Berücksichtigung der Messunsicherheiten, ein Wert von 3.17 ± 0.08 errechnet.

### Beispiel 3: Integrationsdichte 150 pF/mm²:

Analog zu Beispiel 1 wird eine kupferkaschierte FR4-Leiterplatte oder ein Prepreg mit dem Primer Octadecylphosphonsäure oder Hexadecylphosphonsäure beschichtet. Um die Klebeeigenschaften des Prepregs zu erhalten wird ein photochemisch vernetzendes Expoxidharz verwendet. Die Photovernetzung wird beispielsweise über eine Schattenmaske durchgeführt. Nach dem Abspülen der nicht-vernetzten Bereiche bleiben definierte Dielektriumsbereiche übrig. Kontaktstellen werden freigelegt.

Im Falle der Leiterplatte wird eine Lösung von 1g Polyvinylphenol (Molmasse 8000) mit 0.25 g Polymelamincoformaldehyd -Vernetzter in 8.75g Propylene-glycol-monomethyl-etheracetat gelöst und 40s bei 2000rpm aufgeschleudert und 60s bei 100°C auf einer Hotplate vorgetrocknet. In einem Vakuumofen wird das Novolack-artige Polymer mit dem Formaldehydvernetzer ausgehärtet. Im Anschluss daran werden analog Beispiel 1 Aluminiumelektroden durch Verdampfen (Basisdruck 1*10⁻⁶ mbar) abgeschieden.

Nach einer anderen Ausführungsform der Erfindung kann die Gegenelektrode eine Kupferelektrode, die beispielsweise gesputtert aufgebracht ist, sein.

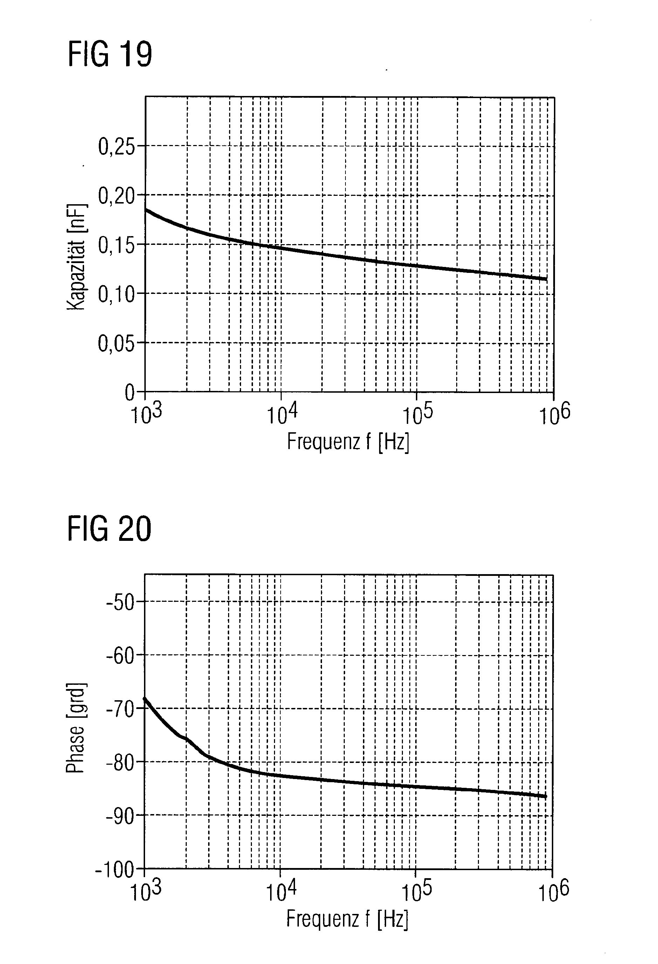

Die elektrischen Kenndaten der Kondensatoren mit einer Integrationsdichte von 150pF/mm²sind in den Figuren 19 bis 22 dargestellt.

Die Figuren 19 bis 22 zeigen die Abhängigkeit der Kapazität (19), der Phase (20), des Verlustfaktors (21) von der Frequenz und Leckstromverhalten (22) der Kondensatoren mit einer Integrationsdichte von 150pF/mm² in Abhängigkeit von dem Kapazitätswert (bzw. Elektrodenfläche).

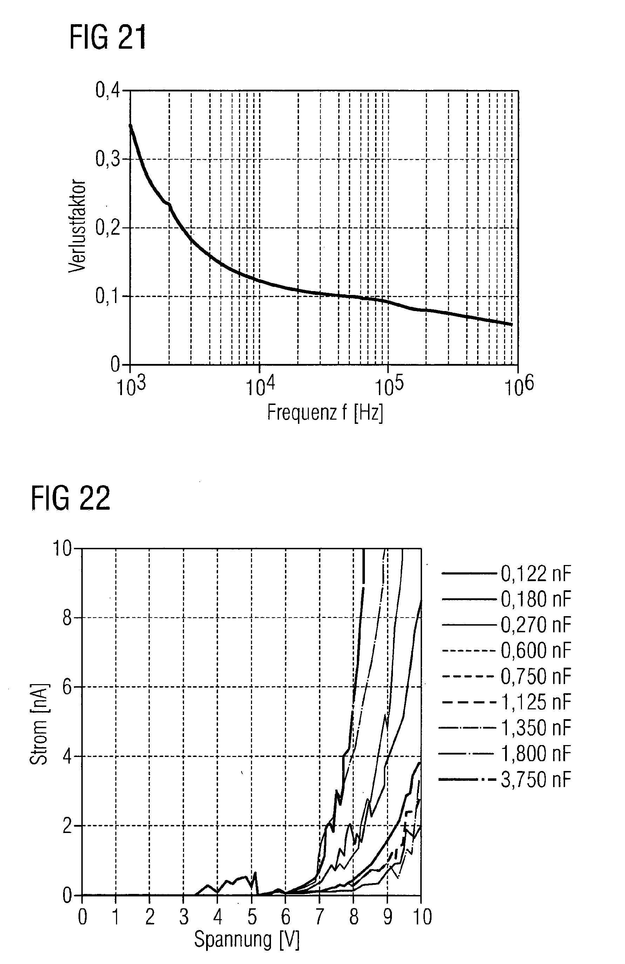

Die Ausbeute an funktionsfähigen Substraten auf einem Substrat analog Beispiel 1 war >> 90%. Figur 19 zeigt die im Wesentlichen von der Frequenz unabhängige Kapazität eines Kondensators der Fläche 1 mm². Der Verlustfaktor lag im Bereich von 0.05 - 0.3 und ist, wie Figur 21 zeigt, ebenfalls nahezu unabhängig von der Frequenz. Figur 22 zeigt den gemessenen Leckstrom für Kondensatoren mit unterschiedlichen Elektrodenflächen. Die Messergebnisse sind im Wesentlichen von dem Kapazitätswert und damit von der Elektrodenfläche unabhängig. Außerdem sind die gemessenen Ströme mit denen in Beispiel 2, Figur 6 und 7 vergleichbar. Bild 23 zeigt den gemessenen ohmschen Widerstand im Ersatzschaltbild des realen Kondensators bei verschiedenen Integrationsdichten bzw. bei verschiedenen effektiven mittleren Polymerschichtdicken (180-200nm für 150pF/mm² und 500 - 600nm für 50pF/mm²). Der Widerstand ist in beiden Fällen gleich.

Figur 23 zeigt den Widerstand des Kondensators gegen DC Strom bei verschieden eingestellten Integrationsdichten.

Die Tatsache, dass die gemessenen Widerstände in Bild 23 gleiche Verläufe aufweisen zeigt, dass der wesentliche Beitrag zum ohmschen Gesamtwiderstand des Kondensators gegen Gleichstrom von der selbstorganisierenden Monolage geleistet wird. Die Qualität der abgeschiedenen SAM-Schicht ist deshalb tragend einerseits für die guten Isolationseigenschaften und andererseits für eine gute Ausbeute der realisierten Kondensatoren. Figur 24 zeigt, dass der Prozess eine geringe Dynamik hat. Nach 10 Sekunden Einlegzeit ist der Kontaktwinkel nur um 1,1° kleiner als nach 10 Minuten und 1,9° kleiner als nach einer Stunde. Der Winkel bleibt dann nach wiederholten Messungen bei einem Mittelwert von 135° ± 0.8° auch nach 72 Stunden Einlegzeit der Proben in der SAM - Lösung.

Figur 24 zeigt die Abhängigkeit des gemessenen Kontaktwinkels nach der SAM-Beschichtung der Leiterplatte von der Einlegezeit der Probe in der Lösung.

Nach einer weiteren Ausführungsform wird die Polymerschicht in ABS (Acrylnitril-Butadien-Styrol) ausgeführt. Dies wird nach Standardmethoden mit Palladium strukturiert bekeimt und die Deckelektroden aus Kupfer oder Nickel stromlos abgeschieden.

Hier werden erstmals Kondensatoren beschrieben, die sich in einem Parallelprozess auf einem Prepreg oder anderen gängigen Leiterplattensubstraten herstellen lassen. Im Anschluss daran kann die vorgefertigte Kondensatorlage in die Leiterplatte integriert werden, wodurch sich für die Oberfläche der Leiterplatte ein Platz-/Kostengewinn ergibt.

Die Topographie des Kondensators ist im Bezug auf die Rauhigkeit des Grundsubstrats äußerst gering. Der Stand der Technik geht davon aus, dass sich selbstorganisierende Monolagen nicht auf Kupfer abscheiden lassen. Hier wird gezeigt, dass sich selbstorganisierende Monolagen (SAM) mit Phosphonsäureanker sehr gut und schnell auf Kupfer abscheiden lassen, nachdem die Kupferoberfläche entsprechend gereinigt wurde. Diese Schicht bildet die eigentliche Isolationslage des Kondensators. Zur mechanischen Stabilisierung wird eine dünne Polymerschicht auf die SAM aufgebracht. Der Deckkontakt kann vielfältig ausgeführt sein.

## Patentansprüche

1. Kondensator, der in eine Leiterplatte, einen Prepreg oder eine Platine integriert ist, wobei die Platine, Leiterplatte oder das Prepreg als Substrat dient, das als Kupfersubstrat oder Kupfer enthaltendes Substrat ausgebildet ist, auf welchem Substrat eine elektrisch isolierende organische Zwischenschicht und eine auf diese folgende Schicht ausgebildet sind, wobei die elektrisch isolierende organische Zwischenschicht als eine als selbstorganisierende Monolage ausgebildete organische Verbindung mit einer Ankergruppe auf einer Kupferschicht oder Kupfer enthaltenden Schicht, einer Linkergruppe und einer Kopfgruppe zur Anbindung an die folgende Schicht, wobei die Ankergruppe zumindest eine Phosphonsäure und/oder ein Phosphonsäurederivat enthält, die/das direkt auf dem Kupfersubstrat oder dem Kupfer enthaltenden Substrat anknüpft, ausgebildet ist.

2. Kondensator nach einem der Ansprüche 1, der eine Deckelektrode aus Kupfer oder Nickel umfasst.

3. Kondensator nach einem der vorangehenden Ansprüche, wobei die Ankergruppe eine langkettige Phosphonsäure umfasst.

4. Kondensator nach einem der vorangehenden Ansprüche, wobei die Ankergruppe eine Decyl- bis Octadecylphosphonsäure, allgemein CH₃-(CH₂)ₙ-PO(OH)₂, wobei n = 8 - 25, bevorzugt n = 18 umfasst.

5. Kondensator nach einem der vorangehenden Ansprüche, wobei die Linkergruppe eine Polyetherkette (-O-CH₂-CH₂-O-)ₘ, wobei m zwischen 1 und 20 liegt, ist.

6. Kondensator nach einem der vorangehenden Ansprüche, wobei angrenzend an die Monolage zumindest auf einer Seite der Monolage eine dünne Polymerlage angeordnet ist.

7. Kondensator nach Anspruch 6, wobei die Polymerlage aus Polyhydroxystyrol ist.

8. Kondensator nach Anspruch 7, wobei das Polyhydroxystyrol eine Molmasse im Bereich von 500 bis 15 000 hat.

9. Kondensator nach Anspruch 7 oder 8, wobei das Polyhydroxystyrol durch Melamin-Co-formaldehyd vernetzt ist.

10. Kondensator nach einem der vorstehenden Ansprüche 6 bis 9, wobei die Polymerlage ein Polymer wie ein Epoxid, Acrylat, Urethan und/oder Carbonat umfasst.

11. Kondensator nach einem der Ansprüche 6 bis 10, wobei die Polymerlage eine Schichtdicke im Bereich von kleiner 1 µm hat.

12. Kondensator nach einem der Ansprüche 6 bis 11, wobei die Polymerlage ein Polymer mit einer Molmasse im Bereich von 1000 und 1 000 000 umfasst.

## Claims

1. Capacitor integrated into a circuit board, a prepreg or a blank, wherein the blank, circuit board or prepreg serves as a substrate which takes the form of a copper substrate or a copper-containing substrate, on which substrate an electrically insulating organic intermediate layer and a layer which follows this layer are formed, the electrically insulating organic intermediate layer taking the form of an organic compound which is in the form of a self-assembly monolayer and has an anchor group on a copper layer or copper-containing layer, a linker group and a head group for attachment to the layer which follows, wherein the anchor group contains at least one phosphonic acid and/or a phosphonic acid derivative which attaches directly to the copper substrate or the copper-containing substrate.

2. Capacitor according to Claim 1, which comprises an outer electrode composed of copper or nickel.

3. Capacitor according to any of the preceding claims, wherein the anchor group comprises a long-chain phosphonic acid.

4. Capacitor according to any of the preceding claims, wherein the anchor group comprises a decyl- to octadecylphosphonic acid, in general terms CH₃-(CH₂)ₙ-PO(OH)₂, where n = 8-25, preferably n = 18.

5. Capacitor according to any of the preceding claims, wherein the linker group is a polyether chain (-O-CH₂-CH₂-O-)ₘ where m is from 1 to 20.

6. Capacitor according to any of the preceding claims, wherein a thin polymer layer is arranged adjoining at least one side of the monolayer.

7. Capacitor according to Claim 6, wherein the polymer layer is composed of polyhydroxystyrene.

8. Capacitor according to Claim 7, wherein the polyhydroxystyrene has a molar mass in the range from 500 to 15 000.

9. Capacitor according to Claim 7 or 8, wherein the polyhydroxystyrene has been crosslinked by melamine-co-formaldehyde.

10. Capacitor according to any of the preceding Claims 6 to 9, wherein the polymer layer comprises a polymer such as an epoxide, acrylate, urethane and/or carbonate.

11. Capacitor according to any of Claims 6 to 10, wherein the polymer layer has a layer thickness in the region of less than 1 µm.

12. Capacitor according to any of Claims 6 to 11, wherein the polymer layer comprises a polymer having a molar mass in the range from 1000 to 1 000 000.

## Revendications

1. Condensateur, qui est intégré dans une plaquette à circuit imprimé, dans un préimprégné ou dans une platine, dans lequel la platine, la plaquette à circuit imprimé ou le préimprégné sert de substrat, qui est constitué sous la forme d'un substrat en cuivre ou d'un substrat contenant du cuivre, substrat sur lequel sont formées une couche intermédiaire organique isolante du point de vue électrique et une couche suivant celle-ci, la couche intermédiaire organique isolante du point de vue électrique étant constituée sous la forme d'un composé organique constitué sous la forme d'une monostrate s'organisant de soi-même, ayant un groupe d'accrochage à une couche de cuivre ou à une couche contenant du cuivre, un groupe de liaison et un groupe de tête pour la fixation à la couche suivante, le groupe d'accrochage contenant au moins un acide phosphonique et/ou un dérive d'acide phosphonique, qui s'attache direction au substrat de cuivre ou au substrat contenant du cuivre.

2. Condensateur suivant la revendication 1, qui comprend une électrode de recouvrement en cuivre ou en nickel.

3. Condensateur suivant l'une des revendications précédentes, dans lequel le groupe d'accrochage comprend un acide phosphonique à longue chaîne.

4. Condensateur suivant l'une des revendications précédentes, dans lequel le groupe d'accrochage comprend un acide décyle à octadécyle phosphonique, d'une manière générale CH₃-(CH₂)ₙ-PO(OH)₂, dans laquelle n = 8 à 25, de préférence n = 18.

5. Condensateur suivant l'une des revendications précédentes, dans lequel le groupe de liaison est une chaîne polyéther (-O-CH₂-CH₂-O-)ₘ, dans laquelle m est compris entre 1 et 20.

6. Condensateur suivant l'une des revendications précédentes, dans lequel, au voisinage de la monostrate, est disposée, au moins sur une face de la monostrate, une strate mince en polymère.

7. Condensateur suivant la revendication 6, dans lequel la strate en polymère est en polyhydroxystyrène.

8. Condensateur suivant la revendication 7, le polyhydroxystyrène a une masse molaire allant de 500 à 15 000.

9. Condensateur suivant la revendication 7 ou 8, le polyhydroxystyrène est réticulé par du mélamine-Co-formaldéhyde.

10. Condensateur suivant l'une des revendications précédentes 6 à 9, dans lequel la strate en polymère comprend un polymère comme un époxyde, un acrylate, un uréthane et/ou un carbonate.

11. Condensateur suivant l'une des revendications 6 à 10, dans lequel la strate en polymère a une épaisseur de couche dans la plage plus petite que 1 µm.

12. Condensateur suivant l'une des revendications 6 à 11, dans lequel la strate en polymère comprend un polymère ayant une masse molaire comprise entre 1 000 et 1 000 000.
